# EUROPEAN PATENT SPECIFICATION

(11) **EP 1 661 187 B1**
(45) Date of publication and mention of the grant of the patent: **11.03.2009**
(21) Application number: 04761207.2
(22) Date of filing: 30.08.2004
(51) Int. Cl.: H01L 31/052, H02N 6/00

(54) **EXTRACTING HEAT FROM AN OBJECT**
EXTRAHIEREN VON WÄRME AUS EINEM OBJEKT
EXTRACTION DE CHALEUR D'UN OBJET

(30) Priority: 29.08.2003 US 498601 P
(43) Date of publication of application: 31.05.2006
(73) Proprietor: Solar Systems Pty Ltd, Hawthorn, Victoria 3122 (AU)
(72) Inventor: LASICH, John, Beavis, Balwyn, Victoria 3103 (AU)
(74) Representative: Lerwill, John
(86) International application number: PCT/AU2004/001170
(87) International publication number: WO 2005/022652

(56) References cited:
- WO-A1-96/07857
- WO-A1-99/09356
- WO-A1-02/080286
- WO-A2-01/94006
- GB-A- 1 541 221
- US-A- 4 235 221
- US-A- 5 092 767
- US-A1- 2001 007 261
- US-A1- 2002 189 662

## Description

The present invention relates to an assembly for extracting heat from an object.

The present invention relates generally to extracting heat from objects in situations where high rates of heat transfer are required in relatively confined spaces with low energy input to extract the heat.

One such situation is the extraction of heat from an array of photovoltaic cells in a concentrated solar radiation-based electrical power generating system and the present invention is described hereinafter, by way of example, in the context of this application but is not limited to this application.

Solar radiation-based electrical power generating systems typically include:
(a) a receiver that includes (i) an array of photovoltaic cells that convert solar energy into electrical energy and (ii) an electrical circuit for transferring the electrical energy output of the photovoltaic cells; and
(b) a means for concentrating solar radiation onto the photovoltaic cells of the receiver.

The present invention is applicable particularly, although by no means exclusively, to large scale solar radiation-based electrical power generating systems of the type described above that are capable of producing substantial amounts of electrical power ready for conditioning to at least 20kW of standard 3 phase 415 volt AC power.

Applications for such large scale power generating systems include remote area power supply for isolated grids, mains grid-connected power, water pumping, telecommunications, crude oil pumping, water purification, and hydrogen generation.

One significant issue associated with the development of commercially viable solar radiation-based electrical power generating systems of the type described above is being able to extract sufficient heat from the photovoltaic cell array to facilitate long term performance of materials of the cell array in situations in which there is:
(a) exposure to extremely high intensity solar radiation capable of producing high temperatures, i.e. temperatures considerably above 1000°C;
(b) cycling between high and low intensities of solar radiation;
(c) temperature variations between different parts of the cell array; and
(d) different rates of thermal expansion of different materials that make up the cell array and associated components.

In large scale solar radiation-based electrical power generating systems of the type described above the photovoltaic cells are exposed to solar radiation intensities of at least 200 times the intensity of the Sun during optimum operating conditions. In addition, the photovoltaic cells are subjected to significant cycling between extremely high and low levels of solar radiation and to variations in solar radiation intensity across the surface of the receiver.

International application PCT/AU02/00402 in the name of the applicant discloses a receiver of a solar radiation-based electrical power generating system that includes a plurality of cell modules that are connected together electrically. The International application discloses that each module includes a plurality of photovoltaic cells and a particular form of an assembly for extracting heat from the array of photovoltaic ells.

An object of the present invention is to provide an alternative heat extraction assembly for a cell array that makes it possible for the cell array to be sufficiently cooled to withstand long term exposure to extremely high intensities of solar radiation, cycling between extremely high and low intensities of solar radiation, temperature variations between different sections of components of the modules and the receiver, and different rates of thermal expansion of different materials that make up the cell array.

In US2002/0189662A1 there is described a device for producing solar energy and water which includes a roof structure with modules adapted to plug together, each module including a photovoltaic element and a cooling device that is disposed underneath the photovoltaic element and has the form of a through-flow device, such as one or more flow lines laid rectilinearly, in a meandering fashion or in the form of loops or helices between inlet and outlet connections for the cooling fluid.

US-A-4235221 discloses a solar energy system and apparatus including solar energy collecting elements disposed over or floated on a body of water such as a lake, reservoir, on a body of water such as a lake, reservoir, bay, pond, ocean or sea. A compositive type solar energy collecting panel section includes an insulating channel form provided with transparent cover plates and housing layers of thermoelectric elements, and a thermal collecting and absorbing fluid tube bonded between thermal absorbing and conducting plates located below the layers of thermoelectric elements.

In general terms, the present invention provides a photovoltaic cell module for a receiver of solar radiation-based electrical power generating system. The module includes an assembly for extracting heat from the photovoltaic cells. The heat extraction assembly , includes a coolant chamber positioned behind and in thermal contact with the exposed surface of the photovoltaic cells. The coolant chamber includes an inlet for a coolant and an outlet for heated coolant. The heat extraction assembly also includes a plurality of beads, rods, bars or balls of high thermal contact with the photovoltaic cells and each other and together have a large surface are for heat transfer and define a three dimensional labyrinth within the coolant chamber that can conduct heat therethrough away from the photovoltaic cell or cells to coolant flowing through the labyrinth from the inlet to the outlet of the coolant chamber.

In more specific terms, according to the present invention there is provided a photovoltaic cell module for a receiver of solar radiation-based electrical power generating system, the module including:
(a) one or more than one photovoltaic cell having an exposed surface for solar radiation;
(b) an electrical connection for transferring the electrical energy output of the photovoltaic cell or cells to an output circuit, and
(c) an assembly for extracting heat from the photovoltaic cell or cells, the assembly including (i) a housing positioned behind and in thermal contact with the exposed surface of the photovoltaic cell or cells, the housong including a base and side walls extending from the base, with the base, the side walls and the photovoltaic cell or cells defining a coolant chamber, and the housing including an inlet for supplying a coolant into the chamber and an outlet for discharging the coolant from the chamber, and (ii) a coolant member located in the coolant chamber in heat transfer relationship with the photovoltaic cell or cells, the coolant member including a plurality of beads, rods, bars or balls of high thermal conductivity material that are in thermal contact and have a large surface area for heat transfer and define a three dimensional labyrinth that can conduct heat therethrough away from the photovoltaic cell or cells via the substantial number of heat transfer pathways formed by the thermally connected beads, rods, bars or balls and has a substantial number of coolant flow passages for a coolant that, in use of the module, is supplied to the coolant chamber via the inlet and flows through the coolant member and is discharged from the coolant chamber via the outlet.

The invention is a simple, economic, compact, efficient heat sink based on a labyrinth of thermally conductive material and voids with optimised ratios for heat conductance located within a coolant chamber and capable of extracting substantial amounts of heat from the photovoltaic cell/cells. The labyrinth has a large surface area for high heat transfer to the coolant, an optimised void space to facilitate sufficient coolant flow to remove concentrated heat energy from the photovoltaic cell/cells with low pressure drop of coolant and consequential low coolant pumping power required to circulate the coolant. In particular, the heat sink of the invention achieves necessary heat extraction from the photovoltaic cell/cells within a significant constraint of locating the heat sink wholly behind the projected cell area and thereby allowing the exposed receiver area to be entirely comprised of photovoltaic cell/cells. This space constraint is not encountered with heat sinks used in other non-solar energy applications and is a significant constraint in the context of solar radiation-based electrical power generating systems.

The applicant has found that the above-described cell module, which is characterised by a substantial number of heat transfer pathways formed by the thermally contacting beads, rods, bars or balls and the substantial number of coolant flow passages, is capable of extracting significant amounts of heat generated by incident concentrated solar radiation in an economical, efficient and reliable manner. In particular, the applicant has found that the labyrinth structure of the coolant member makes it possible to direct heat energy progressively away from the photovoltaic cell or cells and the beads, rods, bars or balls of high thermal conductivity material and thereafter to the coolant.

Thus, the cell module addresses the significant issue that a large portion of incident concentrated radiation on photovoltaic cells of receivers of large scale solar radiation-based electrical power generating systems is not converted to electricity and manifests itself as heat that would normally reduce the efficiency of photovoltaic cells substantially by increasing their operating temperature.

In particular, the applicant has found that the above-described cell module makes it possible to extract sufficient heat generated by incident concentrated solar radiation so that the temperature difference between the inlet coolant temperature and the front faces of the photovoltaic cells is less than 40°C, typically less than 30°C, more typically less than 25°C, and in recent test work less that 20°C and that this result can be achieved with a low pressure drop of coolant, typically less than 100 kPa, typically less than 60 kPa, and more typically less than 40 kPa across the coolant inlet and coolant outlet of the cell module. The low pressure drop is an important consideration because it means that it is possible to minimise the energy requirements for circulating coolant through the module.

In one set of specific test work the applicant has found that the above-described cell module could be operated to maintain a temperature difference of 20.5°C between the inlet coolant temperature and the front faces of the photovoltaic cells and that under these operating conditions 30 W heat per cm² of exposed surface area of cell was being removed from the above-described cell module, 8.1 W electricity per cm² of exposed cell surface area was generated by the module, and 6 W heat per cm² of exposed surface area of cell was reflected by the module as infrared radiation. The coolant flow path of the module 23 forms part of the coolant circuit. In total, the cell had incident on it and processed a total of 44.1 W power (in the forms of heat, electricity, and infrared radiation) per cm² of exposed surface area of cell. Normally, an energy density of this level would produce temperatures of at least 600°C and at these temperatures the cell would be destroyed.

In addition, the applicant has found that the above-described cell module can be manufactured relatively inexpensively and with consistent performance.

Preferably the heat extraction assembly is located wholly behind and does not extend laterally beyond the exposed surface area of the photovoltaic cell or cells.

Preferably the coolant member includes beads, rods, bars or balls of high thermal conductivity material that are thermally connected together by sintering the beads, rods, bars or balls together. One advantage of sintering over some other options for connecting the beads, rods, bars or balls together is that there is direct contact between the beads, rods, bars or balls and the direct contact optimises heat transfer between the beads, rods, bars or balls.

Preferably the surface area for heat transfer provided by the beads, rods, bars or balls of high thermal conductivity material is at least 5, and more preferably at least 10, times the surface area of the front surface of the mass of beads, rods, bars or balls of high thermal conductivity material that are in direct contact with the substrate. Consequently, the coolant member is a particularly effective heat transfer member.

Preferably the coolant member at least substantially occupies the volume of the coolant chamber.

Preferably the coolant inlet is located in one side wall of the housing or in the base of the housing in the region of that side wall and the coolant outlet is located in an opposed side wall or in the base in the region of that side wall.

With this arrangement, preferably the coolant member is shaped so that the coolant chamber includes a manifold in fluid communication with the coolant inlet extending along the inlet side wall and a manifold in fluid communication with the coolant outlet extending along the outlet side wall. The applicant has found in test work that this arrangement of inlet and outlet manifolds ensures that the pressure drop encountered through any flow path parallel to the plane of the photovoltaic cell or cells is substantially equal thereby facilitating even cooling throughout the entire area of the heat sink. This is an important issue in situations where the heat extraction assembly is located wholly behind and does not extend laterally beyond the surface area of the photovoltaic cell or cells. Where the heat sink extends laterally beyond the extent of the device being cooled, even cooling is not an issue.

Preferably the housing includes a weir extending upwardly from the base inwardly of the inlet side wall and defining a barrier to coolant flow across the coolant chamber from the coolant inlet.

Preferably the housing includes a weir extending upwardly from the base inwardly of the outlet side wall and defining a barrier to coolant flow from the coolant chamber to the coolant outlet.

The applicant has found in test work that the weirs improve the distribution of coolant through the coolant chamber and thereby minimise temperature variations within the chamber and increase the overall thermal conductance of the heat extraction assembly. In particular, the weir on the inlet side causes preferential flow of coolant from the inlet side away from the base and towards the plane of the photovoltaic cell or cells and thereafter parallel to the cell/cells towards the weir on the outlet side. The weir on the outlet side preferentially directs heated coolant flow away from the cell/cells towards the base and from the housing. The end result is that the weirs concentrate coolant flow in the upper sections of the coolant chamber where maximum higher levels of heat extraction are required.

Preferably the beads, rods, bars or balls of the high thermal conductivity material have a major dimension of 0.8 - 2.0 mm.

More preferably the beads, rods, bars or balls of the high thermal conductivity material have a major dimension of 0.8 - 1.4 mm.

Test work carried out by the applicant was based on the use of cylindrical rods of 1.2 mm diameter and 1.3 mm length. The rods were formed by cutting 1.2 mm diameter electrical wire.

Preferably the packing density of the beads, rods, bars or balls of the high thermal conductivity material decreases with distance away from the substrate. This feature facilitates heat transfer away from the from the photovoltaic cell or cells.

Preferably the coolant flow passages occupy between 20 and 30 % of the volume of the coolant member.

It is noted that in any given situation there is a need to strike a balance between the volume occupied by the beads, rods, bars or balls of high thermal conductivity material (ie the heat sink capacity of the coolant member), the amount of surface area for heat transfer provided by the beads, rods, bars or balls (ie the capacity of the coolant member to transfer heat to the coolant), and the void space available for flow of the coolant through the coolant member (ie the capacity of the coolant member to allow coolant flow therethrough). The volume and surface area of the beads, rods, bars or balls and he void space are interrelated and may have a competing impact on each other that needs to be considered on a case by case basis when designing a coolant member for a given situation.

Preferably the coolant member acts as a heat sink.

The coolant member may be formed from any suitable high thermal conductivity material.

Preferably the high thermal conductivity material is copper or a copper alloy.

Preferably the copper or a copper alloy is resistant to corrosion and/or erosion by the coolant.

Preferably the cell module includes a substrate on which the photovotaic cell or cells are mounted and to which the housing is mounted.

Preferably the substrate is formed from or includes one or more than one layer of a material that is an electrical insulator.

Preferably the substrate is formed from a material that has a high thermal conductivity.

One suitable material for the substrate is aluminium nitride. This ceramic material is an electrical insulator and has a high thermal conductivity.

Preferably the substrate includes a metallised layer interposed between the photovoltaic cell or cells and the electrical insulator layer or layers.

Preferably the substrate includes a metallised layer interposed between the electrical insulator layer or layers and the coolant member.

According to the present invention there is provided a method of manufacturing the above-described photovoltaic cell module that includes:
(a) forming the coolant member by supplying a predetermined mass of plurality of beads, rods, bars or balls of high thermal conductivity material into a mould of a predetermined shape and thereafter heating the beads, rods, bars or balls of high thermal conductivity material and sintering the beads, rods, bars or balls of together to form the coolant member;
(b) locating the coolant member in the housing; and
(c) mounting the photovotaic cell or cells to the housing.

According to the present invention there is provided a method of manufacturing the above-described photovoltaic cell module that includes:
(a) forming the coolant member by supplying a predetermined mass of plurality of beads, rods, bars or balls of high thermal conductivity material into the housing and thereafter heating the beads, rods, bars or balls of high thermal conductivity material and sintering the beads, rods, bars or balls of together to form the coolant member within the housing; and
(b) mounting the photovotaic cell or cells to the housing, for example by soldering or sintering the substrate to the housing.

Preferably the above-described methods include grinding the surface of the coolant member that forms a contact surface with the substrate to increase the surface area of contact between the beads, rods, bars or balls of high thermal conductivity material and the substrate.

According to the present invention there is provided a method of manufacturing the above-described photovoltaic cell module that includes forming the coolant member by supplying a predetermined mass of plurality of beads, rods, bars or balls of high thermal conductivity material into the housing and locating the substrate on the housing and thereafter heating the beads, rods, bars or balls of high thermal conductivity material and sintering the beads, rods, bars or balls of together to form the coolant member within the housing and bonding the coolant member to the housing and the substrate. One advantage of this method is that there is a better thermally conductive connection between the substrate and the coolant member than is achieved with a soldered connection.

According to the present invention there is also provided a system for generating electrical power from solar radiation which includes:
(a) a receiver that includes a plurality of photovoltaic cells for converting solar energy into electrical energy and an electrical circuit for transferring the electrical energy output of the photovoltaic cells; and
(b) a means for concentrating solar radiation onto the receiver; and
the system being characterised in that the receiver includes a plurality of the above-described photovoltaic cell modules, an electrical circuit that includes the photovoltaic cells of each module, and a coolant circuit that includes the heat extraction assembly of each module.

Preferably in use the coolant maintains the photovoltaic cells at a temperature of no more than 80°C.

More preferably in use the coolant maintains the photovoltaic cells at a temperature of no more than 70°C.

It is preferred particularly that in use the coolant maintains the photovoltaic cells at a temperature of no more than 60°C.

It is preferred more particularly that in use the coolant maintains the photovoltaic cells at a temperature of no more than 40°C.

Preferably the receiver includes a frame that supports the modules in an array of the modules.

Preferably the support frame supports the modules so that the photovoltaic cells form an at least substantially continuous surface that is exposed to reflected concentrated solar radiation.

The surface may be flat, curved or stepped in a Fresnel manner.

Preferably the support frame includes a coolant flow path that supplies coolant to the coolant inlets of the modules and removes coolant from the coolant outlets of the modules.

Preferably the coolant is water.

Preferably the water inlet temperature is as cold as can be obtained reasonably.

Typically, the water inlet temperature is in the range of 10-30°C.

Typically the water outlet temperature is in the range of 20-40°C.

Preferably the means for concentrating solar radiation onto the receiver is a dish reflector that includes an array of mirrors for reflecting solar radiation that is incident on the mirrors towards the photovoltaic cells.

Preferably the surface area of the mirrors of the dish reflector that is exposed to solar radiation is substantially greater than the surface area of the photovoltaic cells that is exposed to reflected solar radiation.

The present invention is described further by way of example with reference to the accompanying drawings, of which:
Figure 1 is a perspective view of a preferred embodiment of a system for generating electrical power from solar radiation in accordance with the present invention;
Figure 2 is a front view of the receiver of the system shown in Figure 1 which illustrates the exposed surface area of the photovoltaic cells of the receiver;
Figure 3 is a partially cut-away perspective view of the receiver with components removed to illustrate more clearly the coolant circuit that forms part of the receiver;
Figure 4 is an exploded perspective view of an embodiment of a photovoltaic cell module in accordance with the present invention that forms part of the receiver;
Figure 5 is a top plan view of the housing of the cell module shown in Figure 4;
Figure 6 is a section along the line 5-5 of Figure 5;
Figure 7 is a perspective view of another embodiment of a housing of a photovoltaic cell module in accordance with the present invention;
Figure 8 is a top plan view of the housing shown in Figure 7; and
Figure 9 is a top plan view of another embodiment of a housing of a photovoltaic cell module in accordance with the present invention.

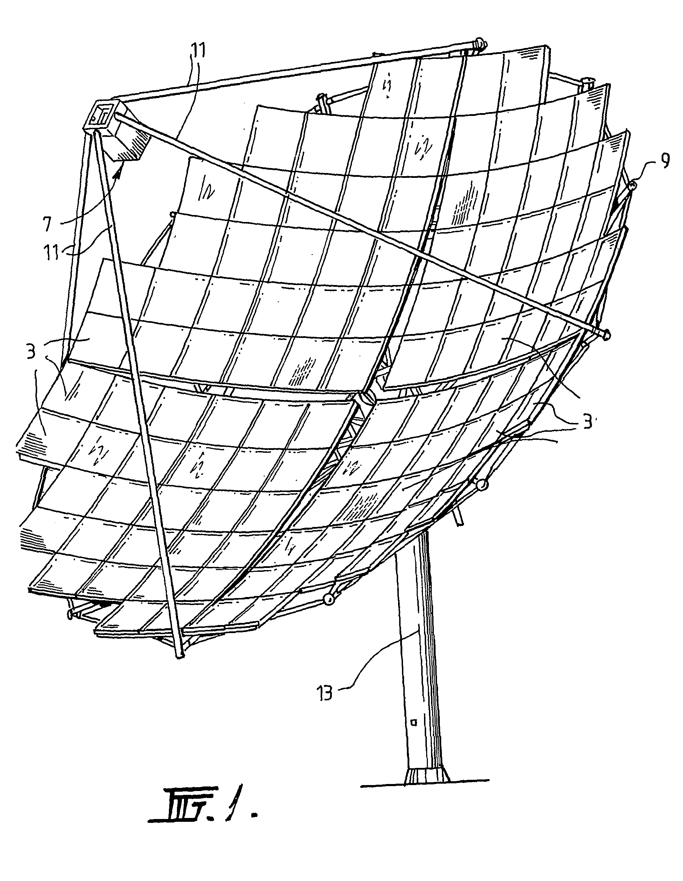

The solar radiation-based electric power generating system shown in Figure 1 includes a parabolic array of mirrors 3 that reflects solar radiation that is incident on the mirrors towards a plurality of photovoltaic cells 5.

The cells 5 form part of a solar radiation receiver that is generally identified by the numeral 7.

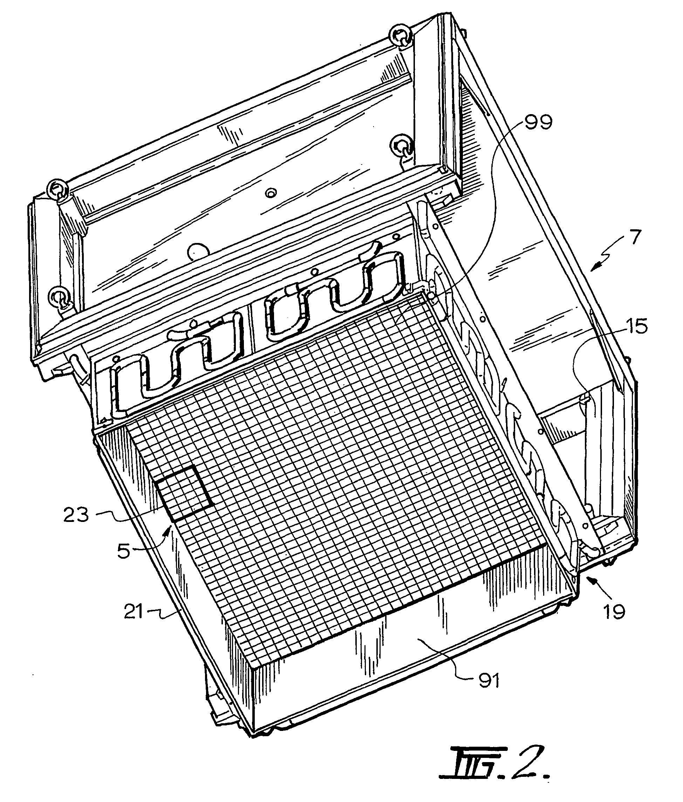

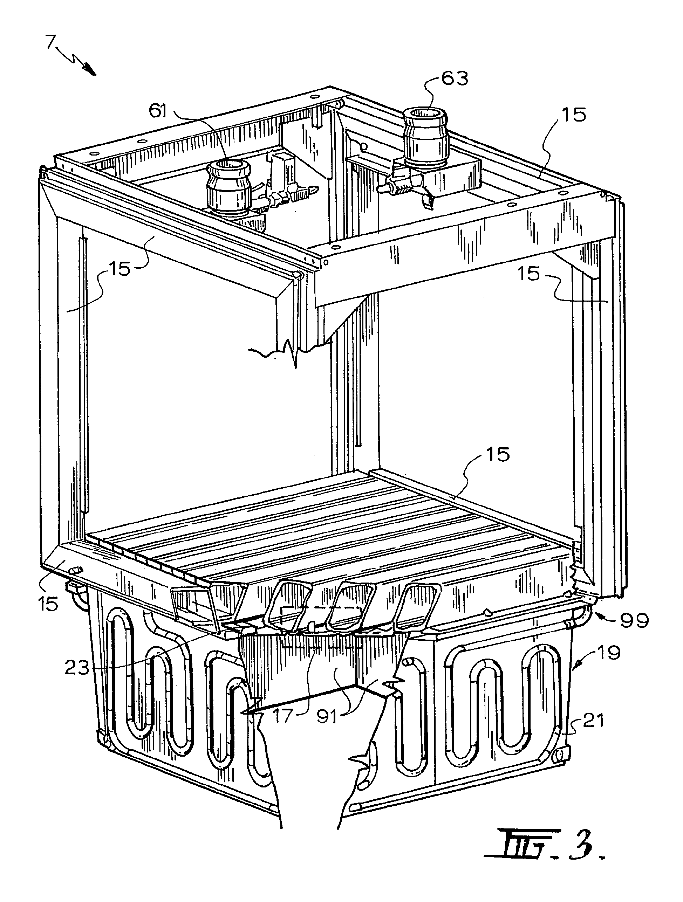

The general arrangement of the receiver 7 is shown in Figures 2 and 3.

Figures 1 to 3 are identical to Figures 1 to 3 of International application PCT/AU02/00402 and the disclosure in the International application is incorporated herein by cross-reference.

The surface area of the mirrors 3 that is exposed to solar radiation is substantially greater than the surface area of the photovoltaic cells 5 that is exposed to reflected solar radiation.

The photovoltaic cells 5 convert reflected solar radiation into DC electrical energy.

The receiver 7 includes an electrical circuit (not shown) for the electrical energy output of the photovoltaic cells.

The mirrors 3 are mounted to a framework 9. The mirrors and the framework define a dish reflector.

A series of arms 11 extend from the framework 9 to the receiver 7 and locate the receiver as shown in Figure 1.

The system further includes:
(a) a support assembly 13 that supports the dish reflector and the receiver in relation to a ground surface and for movement to track the Sun; and
(b) a tracking system (not shown) that moves the dish reflector and the receiver as required to track the Sun.

The receiver 7 also includes a coolant circuit. The coolant circuit cools the photovoltaic cells 5 of the receiver 7 with a coolant, preferably water, in order to minimise the operating temperature and to maximise the performance (including operating life) of the photovoltaic cells 5.

The receiver 7 is purpose-built to include the coolant circuit.

Figures 2 and 3 illustrate components of the receiver that are relevant to the coolant circuit. It is noted that a number of other components of the receiver 7, such as components that make up the electrical circuit of the receiver 7, are not included in the Figures for clarity.

With reference to Figures 2 and 3, the receiver 7 includes a generally box-like structure that is defined by an assembly of hollow posts 15.

The receiver 7 also includes a solar flux modifier, generally identified by the numeral 19, which extends from a lower wall 99 (as viewed in Figure 3) of the box-like structure. The solar flux modifier 19 includes four panels 21 that extend from the lower wall 99 and converge toward each other. The solar flux modifier 19 also includes mirrors 91 mounted to the inwardly facing sides of the panels 21.

The receiver 7 also includes an array of 1536 closely packed rectangular photovoltaic cells 5 which are mounted to 64 square modules 23. The array of cells 5 can best be seen in Figure 2. The term "closely packed" means that the exposed surface area of the photovoltaic cells 5 makes up at least 98% of the total exposed surface area of the array. Each module includes 24 photovoltaic cells 5. The photovoltaic cells 5 are mounted on each module 23 so that the exposed surface of the cell array is a continuous surface. It is noted that the heat extraction assembly 71 described hereinafter makes it possible to provide a receiver with such close packing of photovoltaic cells 5 up to 100%.

The modules 23 are mounted to the lower wall 99 of the box-like structure of the receiver 7 so that the exposed surface of the combined array of photovoltaic cells 5 is a continuous plane.

As is described in more detail hereinafter, each module 23 includes a coolant flow path. The coolant flow path is an integrated part of each module 23. The coolant flow path allows coolant to be in thermal contact with the photovoltaic cells 5 and extract heat from the cells 5 so that the front faces of the cells 5 are maintained at a temperature of no more than 80°C, preferably no more than 60°C, more preferably no more than 40°C.

As is indicated above, in specific test work the applicant found that the above-described cell module could be operated to maintain a temperature difference of 20.5°C between the inlet coolant temperature and the front faces of the photovoltaic cells and that under these operating conditions 30 W heat per cm² of exposed surface area of cell was removed from the above-described cell module, 8.1 W electricity per cm² of exposed cell surface area was generated by the module, and 6 W heat per cm² of exposed surface area of cell was reflected by the module as infrared radiation. The coolant flow path of the module 23 forms part of the coolant circuit. In total, the cell had incident on it and processed a total of 44.1 W power (in the forms of heat, electricity, and infrared radiation) per cm² of exposed surface area of cell. Normally, an energy density of this level would produce temperatures of at least 600°C and at these temperatures the cell would be destroyed.

The coolant circuit also includes the above-described hollow posts 15.

In addition, the coolant circuit includes a series of parallel coolant channels 17 that form part of the lower wall 99 of the box-like structure. The ends of the channels 17 are connected to the opposed pair of lower horizontal posts 15 respectively shown in Figure 3. The lower posts 15 define an upstream header that distributes coolant to the channels 17 and a downstream header that collects coolant from the channels 17. The modules 23 are mounted to the lower surface of the channels 17 and are in fluid communication with the channels so that coolant flows via the channels 17 into and through the coolant flow passages of the modules 23 and back into the channels 17 and thereby cools the photovoltaic cells 5.

The coolant circuit also includes a coolant inlet 61 and a coolant outlet 63. The inlet 61 and the outlet 63 are located in an upper wall of the box-like structure. The inlet 61 is connected to the adjacent upper horizontal post 15 and the outlet 63 is connected to the adjacent upper horizontal post 15 as shown in Figure 3.

In use, coolant that is supplied from a source (not shown) flows via the inlet 61 into the upper horizontal post 15 connected to the inlet 61 and then down the vertical posts 15 connected to the upper horizontal post 15. The coolant then flows into the upstream lower header 15 and, as is described above, along the channels 17 and the coolant flow passages of the modules 23 and into the downstream lower header 15. The coolant then flows upwardly through the vertical posts 15 that are connected to the downstream lower header 15 and into the upper horizontal post 15. The coolant is then discharged from the receiver 7 via the outlet 63.

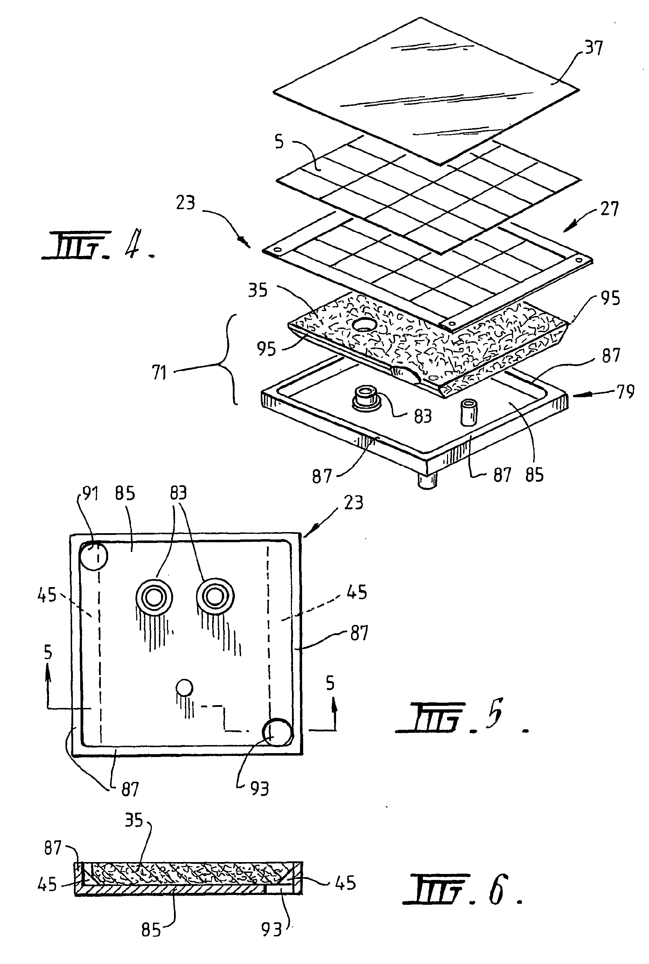

Figures 4 to 6 illustrate the basic construction of one embodiment of each module 23.

As is indicated above, each module 23 includes an array of 24 closely packed photovoltaic cells 5.

Each module 23 includes a substrate, generally identified by the numeral 27, on which the cells 5 are mounted. The substrate includes a central layer (not shown) of a ceramic material and outer metallised layers (not shown) on opposite faces of the ceramic material layer.

Each module 23 also includes a glass cover 37 that is mounted on the exposed surface of the array of photovoltaic cells 5. The glass cover 37 may be formed to optimise transmission of useful wavelengths of solar radiation and minimise transmission of un-wanted wavelengths of solar radiation.

Each module 23 also includes an assembly 71 to facilitate extraction of heat from the photovoltaic cells 5. The assembly 71 is formed from a high thermal conductivity material. A preferred material is copper.

The assembly 71 is located wholly behind and therefore has less cross sectional area than the exposed surfaces of the photovoltaic cells 5.

The assembly 71 includes a housing 79 and a coolant member 35 located in the housing.

The housing 79 includes a base 85 and side walls 87 extending from the base. The substrate 27 is mounted on the housing 79, whereby the base 85, the side walls 87, and the substrate 27 define a coolant chamber.

The housing 79 further includes an inlet 91 for supplying a coolant such as water into the coolant chamber and an outlet 93 for discharging the coolant from the chamber. The inlet 91 is in the form of a circular hole located in the base 85 in one corner of the housing 79. The outlet 93 is in the form of a circular hole located in the base 85 in a diametrically-opposed corner of the housing 79.

The coolant member 35 is shaped to substantially occupy the volume of the coolant chamber. The upper surface 75 of the coolant member is formed as a flat surface and contacts the substrate 27.

The coolant member 35 includes a plurality of beads, rods, bars or balls of high thermal conductivity material that are sintered and thereby thermally connected together and form a porous mass that has a large volume and a large surface area for heat transfer. The beads, rods, bars or balls form a substantial number of continuous heat transfer pathways that extend through the coolant member 35. The mass of beads, rods, bars or balls is a porous rather than a solid mass and there are spaces between the sintered beads, rods, bars or balls. The spaces define a substantial number, typically at least 1000, of continuous coolant flow passages that extend through the coolant member 35. In overall terms the coolant member 35 is in the form of a labyrinth defined by the sintered beads, rods, bars or balls and the coolant flow passages in the spaces between the sintered beads, rods, bars or balls.

The above arrangement is such that, in use, coolant supplied under pressure to the coolant chamber via the coolant inlet 91 flows through the substantial number of coolant flow passageways in the coolant member 35 and discharges from the coolant chamber via the coolant outlet 93. The arrangement is such that the substantial number of heat transfer pathways conduct heat away from the front faces of the cells 5 and the heat conducted through the pathways is transferred to coolant flowing through the substantial number of coolant flow passageways.

In any given situation, factors such as the shape and size of the beads, rods, bars or balls, the packing density of the beads, rods, bars or balls, the volume occupied by the beads, rods, bars or balls, the heat transfer characteristics of the heat transfer pathways formed by the sintered beads, rods, bars or balls, and the volumetric flow rate of coolant through the coolant flow passageways are selected having regard to achieving a target rate of extraction of heat from the module 23.

The opposed end walls 95 of the coolant member 35 that are in the regions of the coolant inlet 91 and the coolant outlet 93 are downwardly tapered so that the end walls 95, the base 85 and the side walls 87 define inlet and outlet manifolds 45 that are in fluid communication with the coolant inlet and outlet and extend along the side walls 87 and therefore can supply coolant to and receive coolant from the whole of the side walls 95 of the coolant member 35.

Each module 23 also includes electrical connections (not shown) that form part of the electrical circuit of the receiver 7 and electrically connect the photovoltaic cells 5 into the electrical circuit. The electrical connections are positioned to extend from the outer metallised layer of the substrate 27 and through one of two hollow sleeves 83 extending from the base 85 of the housing 79.

It is evident from the above that the coolant inlet 91, the coolant manifolds 45, the coolant flow passageways in the coolant member 35, and the coolant outlet 93 define a coolant flow path of each module 23.

As is indicated above, the construction of the coolant member 35 makes it possible to achieve the high levels of heat transfer that are required to maintain the photovoltaic cells 5 at temperatures of no more than 60°C and to accommodate substantially different thermal expansion of the coolant member 35 and the substrate 27 that otherwise would cause structural failure of the modules 23.

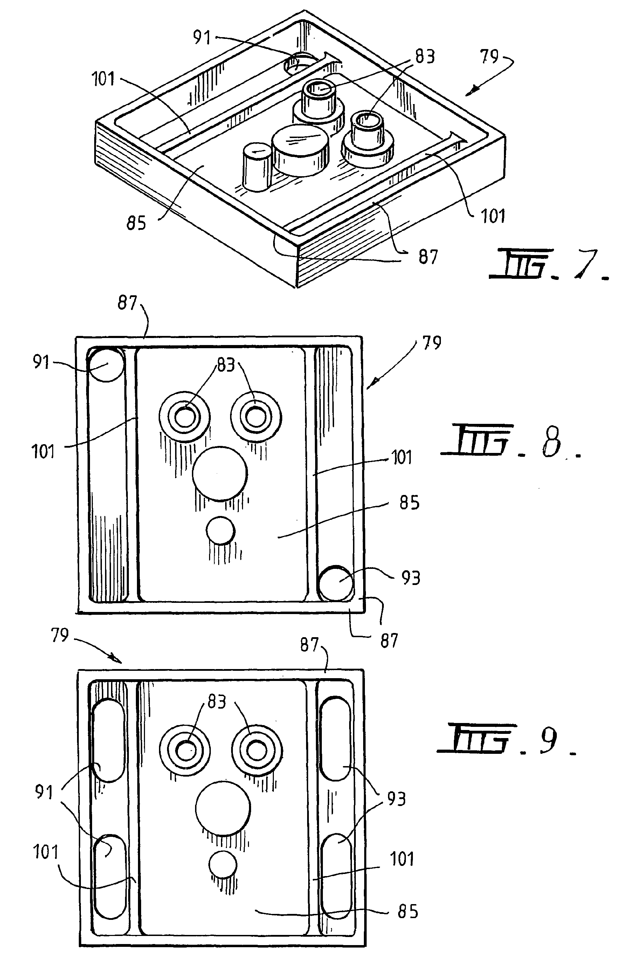

The embodiment of the module 23 shown in Figures 7 and 8 is the basic construction shown in Figures 4 to 6 and the same reference numerals are used to describe the same parts.

In addition, the module 23 includes 2 ridges 101 that extend from the base 85 inboard of and parallel to the inlet and outlet manifolds 45. The ridges 101 form a barrier or weir to coolant flow from and to the inlet and outlet manifolds 45. In general terms, the ridges 101 improve the distribution of coolant through the coolant chamber and thereby minimise temperature variations within the chamber and increase the overall thermal conductance of the heat extraction assembly 71. More specifically, coolant is forced to flow over the inlet ridge 101 in order to flow through the lower coolant flow passageways in the coolant flow member 25 and then over the outlet ridge 101 in order to flow from the lower coolant flow passageways into the outlet manifold 45. Consequently, the ridges 101 increase the path length of coolant through the lower coolant flow passageways compared to the coolant path length through upper coolant flow passageways. The ridges 101 promote greater coolant flow through the upper flow passageways, and this is an advantage in terms of optimising heat transfer from the coolant member 25.

The embodiment of the module 23 shown in Figure 9 is the basic construction shown in Figures 7 and 8 and the same reference numerals are used to describe the same parts. The main difference between the embodiments is that the inlet 91 and the outlet 93 are in the form of slots rather than circular openings. The use of slots has been found to be beneficial in certain circumstances in terms of improving the distribution of coolant through the coolant chamber.

There are a number of options for manufacturing the modules 23 shown in the Figures.

One option includes separately forming the coolant member 35, thereafter positioning the coolant member in the housing 79, and thereafter positioning the substrate 27 on the housing/coolant member. In this option, the coolant member may be formed by formed in a suitable mould and include sintering the mass of beads, rods, bars, balls of high thermal conductivity together. Furthermore, in this option the substrate 27 may be soldered onto exposed edges of the side walls 87 of the housing 79 and the exposed front face of the coolant member 35.

Another option includes placing a mass of beads, rods, bars, balls of high thermal conductivity material directly in the housing 79 and sintering the material in situ in the housing, and thereafter sintering the substrate 27 on to the assembly of the housing 79 and the coolant member 35.

Many modifications may be made to the preferred embodiment described above without departing from the spirit and scope of the present invention.

By way of example, whilst the preferred embodiment includes 1536 photovoltaic cells 5 mounted to 64 modules 23 with 24 cells per module, the present invention is not so limited and extends to any suitable number and size of photovoltaic cells and modules.

By way of further example, whilst the photovoltaic cells are mounted so that the exposed surface of the cell array is a flat surface, the present invention is not so limited and extends to any suitable shaped surface, such as curved or stepped surfaces.

By way of further example, whilst the preferred embodiment includes the receiver coolant circuit that forms part of the support frame of the receiver, the present invention is not so limited and extends to arrangements in which the coolant circuit is not part of the structural frame of the receiver.

By way of further example, whilst the preferred embodiment includes a dish reflector in the form of an array of parabolic array of mirrors 3, the present invention is not so limited and extends to any suitable means of concentrating solar radiation onto a receiver. One such suitable means is a series of heliostats arranged to focus solar radiation on to a receiver.

By way of further example, whilst the preferred embodiment of the receiver is constructed from extruded components, the present invention is not so limited and the receiver may be made by any suitable means.

By way of further example, whilst the preferred embodiment of the coolant member 35 includes a plurality of beads, rods, bars or balls of high thermal conductivity material that are sintered and thereby in thermal contact, the present invention is not so limited and the beads, rods, bars or balls may be connected together thermally in any suitable way. Other options include ultrasonic welding, resistance welding, and plasma processing.

By way of further example, whilst the preferred embodiment is described in the context of the extraction of heat from an array of photovoltaic cells that are contacted by concentrated solar radiation, the present invention is not so limited and extends to the extraction of heat derived from any source of intense radiation.

## Claims

1. A photovoltaic cell module (23) for a receiver (7) of solar radiation-based electrical power generating system, the module including:
(a) one or more than one photovoltaic cell (5) having an exposed surface for solar radiation.
(b) an electrical connection for transferring the electrical energy output of the photovoltaic cell or cells to an output circuit, and
(c) an assembly (71) defining a flowpath for flow of coolant for extracting heat from the photovoltaic cell or cells,
**characterised in that** the assembly (71) includes:
(i) housing (79) positioned behind and in thermal contact with the exposed surface of the photovoltaic cell or cells, the housing including a base (85) and side walls extending from the base, with the base, the side walls and the photovoltaic cell or cells defining a coolant chamber, and the housing including an inlet (91) for supplying a coolant into the chamber and an outlet (93) for discharging the coolant from the chamber; and
(ii) a coolant member (35) located in the coolant chamber in heat transfer relationship, with the photovoltaic cell or cells, the coolant member including plurality of beads, rods, bars or balls (95) of high thermal conductivity material that are in thermal contact and have a large surface area for heat transfer and define a three dimensional labyrinth that can conduct heat therethrough away from the photovoltaic cell or cells (5) via the substantial number of heat transfer pathways formed by the thermally connected beads, rods, bars or balls (95) and has a substantial number of coolant flow passages for a coolant that, in use of the module, is supplied to the coolant chamber via the inlet (91) and flows through the coolant member (35) and is discharged from the coolant chamber via the outlet (93).

2. The cell module defined in claim 1 wherein the heat extraction assembly (71) is located wholly behind and does not extend laterally beyond the exposed surface area of the photovoltaic cell or cells (5).

3. The cell module defined in claim 1 or claim 2 wherein the surface area for heat transfer provided by the beads, rods bars or balls (95) of high thermal conductivity material is at least 5 times the surface area of the front surface of the mass of beads, rods, bars or balls of high thermal conductivity material that are in direct contact with the substrate (27).

4. The cell module defined in any one of the preceding claims wherein the coolant member (35) at least substantially occupies the volume of the coolant chamber.

5. The cell module defined in any one of the preceding claims wherein the coolant inlet (91) is located in one side wall (87) of the housing (79) or in the base (85) of the housing in the region of that side wall and the coolant outlet (93) is located in an opposed side wall (87) or in the base (85) in the region of that side wall.

6. The cell module defined in claim 5 wherein the coolant member (35) is shaped so that the coolant chamber includes a manifold (45) in fluid communication with the coolant inlet (91) extending along the inlet side wall (87) and a manifold (45) in fluid communication with the coolant outlet (93) extending along the outlet side wall (87).

7. The cell module defined in claim 5 or claim 6 wherein the housing (79) includes a weir (101) extending upwardly from the base (85) inwardly of the inlet side wall (87) and defining a barrier to coolant flow across the coolant chamber from the coolant inlet (91).

8. The cell module defined in any one of claims 5 to 7 wherein the housing (79) includes a weir (101) extending upwardly from the base (85) inwardly of the outlet side wall (87) and defining a barrier to coolant flow from the coolant chamber to the coolant outlet (93).

9. The cell module defined if any one of the preceding claims wherein the beads, rods, bars or balls (95) of the high thermal conductivity material have a major dimension of 0.8 - 2.0 mm.

10. The cell module defined in any one of the preceding claims wherein the beads, rods, bars or balls (95) of the high thermal conductivity material have a major dimension of 0.8 - 1.4 mm.

11. The cell module defined in any one of the preceding claim wherein the packing density of the beads, rods, bars or balls (95) of the high thermal conductivity material decreases with distance away from the substrate (27).

12. The cell module defined in any one of the preceding claims wherein the coolant flow passages occupy between 20 and 30 % of the volume of the coolant member.

13. The cell module defined in any one of the preceding claims includes a substrate (27) on which the photovoltaic cell or cells (5) are mounted and to which the housing (79) is mounted.

14. The cell module defined in claim 13 wherein the substrate (27) is formed from or includes one or more than one layer of a material that is an electrical insulator.

15. The cell module defined in claim 13 or claim 14 wherein the substrate (27) is formed from a material that has a high thermal conductivity.

16. The cell module defined in claim 14 wherein the substrate (27) includes a metallised layer interposed between the photovoltaic cell or cells and the electrical insulator layer or layers.

17. The cell module defined in claim 14 or claim 16 wherein the substrate (27) includes a metallised layer interposed between the electrical insulator layer or layers and the coolant member.

18. A method of manufacturing the photovoltaic cell module defined in any one of the preceding claims that includes:
(a) forming the coolant member (35) by supplying a predetermined mass of a plurality of beads, rods, bars or balls (95) of high thermal conductivity material into a mould of a predetermined shape and thereafter heating the beads, rods, bars or balls of high thermal conductivity material and sintering the beads, rods, bars or balls of together to form the coolant member;
(b) locating the coolant member (35) in the housing (79); and
(c) mounting the photovotaic cell on cells (5) to the housing (79).

19. A method of manufacturing the photovoltaic cell module defined in any one of claims 1 to 17 that includes:
(a) forming the coolant member (35) by supplying a predetermined mass of a plurality of beads, rods, bars or balls (95) of high thermal conductivity material into the housing (79) and thereafter heating the beads, rods, bars or balls of high thermal conductivity material and wintering the beads, rods, bars or balls of together to form the coolant member within the housing; and
(b) mounting the photovotaic cell or cells (5) to the housing (79), for example by soldering or sintering the substrate (27) to the housing (79).

20. The method defined in claim 18 or claim 19 includes grinding the surface of the coolant member (35) that forms a contact surface with the substrate to increase the surface area of contact between the beads, rods, bars or balls of high thermal conductivity material and the substrate.

21. A Method of manufacturing the photovoltaic cell module defined in any one of claims 1 to 17 includes forming the coolant member (35) by supplying a predetermined mass of plurality of beads, rods, bars or balls (95) of high thermal conductivity material into the housing (79) and locating the substrate (27) on the housing and thereafter heating the beads, rods, bars or balls (95) of high thermal conductivity material and sintering the beads, rods, bars or balls of together to form the coolant member within the housing and bonding the coolant member (35) to the housing (79) and the substrate (27).

22. A system for generating electrical power from solar radiation which includes:
(a) a receiver (7) that includes a plurality of photovoltaic cells (5) for converting solar energy into electrical energy and an electrical circuit for transferring the electrical energy output of the photovoltaic cells; and
(b) a means (3) for concentrating solar radiation onto the receiver (7); and the system being **characterised in that** the receiver (7) includes a plurality of the photovoltaic cell modules (23) defined in any one of claims 1 to 16, an electrical circuit that includes the photovoltaic cells (5) of each module (23), and a coolant circuit that includes the heat extraction assembly (71) of each module (23).

## Patentansprüche

1. Photovoltaikzellenmodul (23) für einen Empfänger (7) eines auf Sonnenstrahlung basierenden Erzeugungssystems elektrischer Energie, wobei das Modul aufweist:
(a) eine oder mehr als eine Photovoltaikzelle (5) mit einer exponierten Oberfläche für Sonnenstrahlung,
(b) eine elektrische Verbindung zur Übertragung der elektrischen Energieabgabe der Photovoltaikzelle oder Photovoltaikzellen an eine Ausgangsschaltung und
(c) eine Anordnung (71), die einen Strömungsweg für eine Strömung von Kühlmittel zum Extrahieren von Wärme aus der Photovoltaikzelle oder den Photovoltaikzellen bildet,
**dadurch gekennzeichnet, dass** die Anordnung (71) aufweist:
(i) ein Gehäuse (79), das hinter und in thermischem Kontakt mit der exponierten Oberfläche der Photovoltaikzelle oder den Photovoltaikzellen angeordnet ist, wobei das Gehäuse eine Basis (85) und Seitenwände aufweist, die sich von der Basis erstrecken, wobei die Basis, die Seitenwände und die Photovoltaikzelle oder Photovoltaikzellen eine Kühlmittelkammer bilden und das Gehäuse einen Einlass (91) zum Zuführen eines Kühlmittels in die Kammer und einen Auslass (93) zum Abgeben des Kühlmittels aus der Kammer aufweist, und
(ii) ein Kühlmittelelement (35), das sich in der Kühlmittelkammer in Wärmeübertragungsbeziehung mit der Photovoltaikzelle oder den Photovoltaikzellen befindet, wobei das Kühlmittelelement eine Vielzahl von Perlen, Stäben, Stangen oder Kugeln (95) aus einem Material hoher thermischer Leitfähigkeit aufweist, die sich in thermischem Kontakt befinden und eine große Oberfläche zur Wärmeübertragung haben und ein dreidimensionales Labyrinth bilden, das durch es hindurch Wärme weg von der Photovoltaikzelle oder den Photovoltaikzellen (5) über die beträchtliche Anzahl von Wärmetransportwegen leiten kann, die durch die thermisch verbundenen Perlen, Stäbe, Stangen oder Kugeln (95) gebildet werden, und eine beträchtliche Anzahl von Kühlmittelströmungsbahnen für ein Kühlmittel hat, das bei der Verwendung des Moduls der Kühlmittelkammer über den Einlass (91) zugeführt wird und durch das Kühlmittelelement (35) strömt und aus der Kühlmittelkammer über den Auslass (93) abgegeben wird.

2. Zellenmodul nach Anspruch 1, bei dem die Wärmeextraktionsanordnung (71) vollständig hinter der exponierten Oberfläche der Photovoltaikzelle oder Photovoltaikzellen (5) angeordnet ist und sich nicht seitlich über diese hinaus erstreckt.

3. Zellenmodul nach Anspruch 1 oder Anspruch 2, bei dem die Oberfläche zur Wärmeübertragung, die durch die Perlen, Stäbe, Stangen oder Kugeln (95) aus einem Material hoher thermischer Leitfähigkeit bereitgestellt wird, mindestens das Fünffache der Oberfläche der vorderen Fläche der Masse von Perlen, Stäben, Stangen oder Kugeln aus einem Material hoher thermischer Leitfähigkeit beträgt, die sich in direktem Kontakt mit dem Substrat (27) befinden.

4. Zellenmodul nach einem der vorhergehenden Ansprüche, bei dem das Kühlmittelelement (35) zumindest im wesentlichen das Volumen der Kühlmittelkammer einnimmt.

5. Zellenmodul nach einem der vorhergehenden Ansprüche, bei dem der Kühlmitteleinlass (91) in einer Seitenwand (87) des Gehäuses (79) oder in der Basis (85) des Gehäuses in dem Bereich dieser Seitenwand angeordnet ist und der Kühlmittelauslass (93) in einer gegenüberliegenden Seitenwand (87) oder in der Basis (85) in dem Bereich dieser Seitenwand angeordnet ist.

6. Zellenmodul nach Anspruch 5, bei dem das Kühlmittelelement (35) so geformt ist, dass die Kühlmittelkammer eine Sammelleitung (45) in Fluidverbindung mit dem Kühlmitteleinlass (91), die entlang der Einlassseitenwand (87) verläuft, und eine Sammelleitung (45) in Fluidverbindung mit dem Kühlmittelauslass (93) aufweist, die entlang der Auslassseitenwand (87) verläuft.

7. Zellenmodul nach Anspruch 5 oder Anspruch 6, bei dem das Gehäuse (79) einen Vorsprung (101) aufweist, der sich innerhalb von der Einlassseitenwand (87) von der Basis (85) nach oben erstreckt und eine Barriere gegenüber einer Kühlmittelströmung über die Kühlmittelkammer von dem Kühlmitteleinlass (91) bildet.

8. Zellenmodul nach einem der Ansprüche 5 bis 7, bei dem das Gehäuse (79) einen Vorsprung (101) aufweist, der sich innerhalb von der Auslassseitenwand (87) von der Basis (85) nach oben erstreckt und eine Barriere gegenüber einer Kühlmittelströmung von der Kühlmittelkammer zu dem Kühlmittelauslass (93) bildet.

9. Zellenmodul nach einem der vorhergehenden Ansprüche, bei dem die Perlen, Stäbe, Stangen oder Kugeln (95) aus dem Material hoher thermischer Leitfähigkeit eine Hauptabmessung von 0,8 bis 2,0 mm haben.

10. Zellenmodul nach einem der vorhergehenden Ansprüche, bei dem die Perlen, Stäbe, Stangen oder Kugeln (95) aus dem Material hoher thermischer Leitfähigkeit eine Hauptabmessung von 0,8 bis 1,4 mm haben.

11. Zellenmodul nach einem der vorhergehenden Ansprüche, bei dem die Packungsdichte der Perlen, Stäbe, Stangen oder Kugeln (95) aus dem Material hoher thermischer Leitfähigkeit mit dem Abstand weg von dem Substrat (27) abnimmt.

12. Zellenmodul nach einem der vorhergehenden Ansprüche, bei dem die Kühlmittelströmungsbahnen zwischen 20 und 30 % des Volumens des Kühlmittelelements einnehmen.

13. Zellenmodul nach einem der vorhergehenden Ansprüche, das ein Substrat (27) aufweist, an dem die Photovoltaikzelle (5) befestigt ist bzw. die Photovoltaikzellen (5) befestigt sind und an dem das Gehäuse (79) befestigt ist.

14. Zellenmodul nach Anspruch 13, bei dem das Substrat (27) aus einer Schicht aus einem Material ausgebildet ist, das ein elektrischer Isolator ist, oder eine oder mehrere solche Schichten enthält.

15. Zellenmodul nach Anspruch 13 oder Anspruch 14, bei dem das Substrat (27) aus einem Material ausgebildet ist, das eine hohe thermische Leitfähigkeit hat.

16. Zellenmodul nach Anspruch 14, bei dem das Substrat (27) eine metallisierte Schicht enthält, die zwischen der Photovoltaikzelle oder den Photovoltaikzellen und der elektrischen Isolatorschicht oder den elektrischen Isolatorschichten angeordnet ist.

17. Zellenmodul nach Anspruch 14 oder Anspruch 16, bei dem das Substrat (27) eine metallisierte Schicht enthält, die zwischen der elektrischen Isolatorschicht oder den elektrischen Isolatorschichten und dem Kühlmittelelement angeordnet ist.

18. Verfahren zur Herstellung des Photovoltaikzellenmoduls nach einem der vorhergehenden Ansprüche, wobei das Verfahren aufweist:
(a) Ausbilden des Kühlmittelelements (35) durch Zuführen einer vorbestimmten Masse einer Vielzahl von Perlen, Stäben, Stangen oder Kugeln (95) aus einem Material hoher thermischer Leitfähigkeit in eine Form von einer vorbestimmten Form, und danach Erwärmen der Perlen, Stäbe, Stangen oder Kugeln aus einem Material hoher thermischer Leitfähigkeit und Zusammensintern der Perlen, Stäbe, Stangen oder Kugeln, um das Kühlmittelelement zu bilden,
(b) Anordnen des Kühlmittelelements (35) in dem Gehäuse (79) und
(c) Befestigen der Photovoltaikzelle oder der Photovoltaikzellen (5) an dem Gehäuse (79).

19. Verfahren zur Herstellung des Photovoltaikzellenmoduls nach einem der Ansprüche 1 bis 17, wobei das Verfahren aufweist:
(a) Ausbilden des Kühlmittelelements (35) durch Zuführen einer vorbestimmten Masse einer Vielzahl von Perlen, Stäben, Stangen oder Kugeln (95) aus einem Material hoher thermischer Leitfähigkeit in das Gehäuse (79), und danach Erwärmen der Perlen, Stäbe, Stangen oder Kugeln aus einem Material hoher thermischer Leitfähigkeit und Zusammensintern der Perlen, Stäbe, Stangen oder Kugeln, um das Kühlmittelelement innerhalb des Gehäuses zu bilden, und
(b) Befestigen der Photovoltaikzelle oder der Photovoltaikzellen (5) an dem Gehäuse (79), zum Beispiel indem das Substrat (27) an das Gehäuse (79) gelötet oder gesintert wird.

20. Verfahren nach Anspruch 18 oder Anspruch 19, das Schleifen der Oberfläche des Kühlmittelelements (35) umfasst, die eine Kontaktfläche mit dem Substrat bildet, um die Oberfläche des Kontaktes zwischen den Perlen, Stäben, Stangen oder Kugeln aus einem Material hoher thermischer Leitfähigkeit und dem Substrat zu erhöhen.

21. Verfahren zur Herstellung des Photovoltaikzellenmoduls nach einem der Ansprüche 1 bis 17, das das Ausbilden des Kühlmittelelements (35) durch Zuführen einer vorbestimmten Masse einer Vielzahl von Perlen, Stäben, Stangen oder Kugeln (95) aus einem Material hoher thermischer Leitfähigkeit in das Gehäuse (79) und Anordnen des Substrats (27) an dem Gehäuse und danach Erwärmen der Perlen, Stäbe, Stangen oder Kugeln (95) aus einem Material hoher thermischer Leitfähigkeit und Zusammensintern der Perlen, Stäbe, Stangen oder Kugeln, um das Kühlmittelelement innerhalb des Gehäuses zu bilden, und das Verbinden des Kühlmittelelements (35) mit dem Gehäuse (79) und dem Substrat (27) umfasst.

22. System zur Erzeugung elektrischer Energie aus Sonnenstrahlung, das aufweist:
(a) einen Empfänger (7), der eine Vielzahl von Photovoltaikzellen (5) zur Umwandlung von Sonnenenergie in elektrische Energie und eine elektrische Schaltung zur Übertragung der elektrischen Energieabgabe der Photovoltaikzellen enthält, und
(b) eine Einrichtung (3) zum Bündeln von Sonnenstrahlung auf dem Empfänger (7), und
wobei das System **dadurch gekennzeichnet ist, dass** der Empfänger (7) eine Vielzahl von Photovoltaikzellenmodulen (23) nach einem der Ansprüche 1 bis 16, eine elektrische Schaltung, die die Photovoltaikzellen (5) von jedem Modul (23) enthält, und einen Kühlmittelkreislauf enthält, der die Wärmeextraktionsanordnung (71) von jedem Modul (23) enthält.

## Revendications

1. Module de cellule photovoltaïque (23) pour un récepteur (7) d'un système générateur d'électricité utilisant le rayonnement solaire, lequel module comprend :
(a) une ou plusieurs cellules photovoltaïques (5) comportant une surface exposée au rayonnement solaire ;
(b) une connexion électrique pour transférer l'énergie électrique émise par la ou les cellules photovoltaïques vers un circuit de sortie ; et
(c) un assemblage (71) définissant un trajet d'écoulement pour un flux de réfrigérant afin d'extraire la chaleur de la ou des cellules photovoltaïques ;
**caractérisé en ce que** l'assemblage (71) comprend :
(i) un boîtier (79) disposé derrière et en contact thermique avec la surface exposée de la ou des cellules photovoltaïques, le boîtier comprenant une base (85) et des parois latérales s'étendant depuis la base, la base, les parois latérales et la ou les cellules photovoltaïques définissant une chambre de réfrigérant, et le boîtier comprenant une admission (91) pour envoyer le réfrigérant dans la chambre et une sortie (93) pour refouler le réfrigérant hors de la chambre ; et
(ii) un élément réfrigérant (35) disposé dans la chambre de réfrigérant selon une relation de transfert de chaleur par rapport à la ou aux cellules photovoltaïques, l'élément réfrigérant comprenant plusieurs perles, tiges, barres ou billes (95) qui sont faites d'un matériau ayant une grande conductivité thermique, qui sont en contact thermique, et ont une grande superficie pour le transfert de la chaleur, et qui définissent un labyrinthe tridimensionnel qui peut conduire la chaleur à travers lui et l'éloigne de la ou des cellules photovoltaïques (5) par le biais d'un nombre important de trajets de transfert de chaleur formés par les perles, tiges, barres ou billes (95) en connexion thermique, et qui comprend un nombre important de passages d'écoulement de réfrigérant pour un réfrigérant qui, lors de l'utilisation du module, est envoyé vers la chambre de réfrigérant par le biais de l'admission (91) et s'écoule à travers l'élément réfrigérant (35) avant d'être refoulé de la chambre de réfrigérant par la sortie (93).

2. Module de cellule tel que défini dans la revendication 1, dans lequel l'assemblage d'extraction de chaleur (71) est situé entièrement derrière la superficie exposée de la ou des cellules photovoltaïques (5) et ne s'étend pas latéralement au-delà de celle-ci.

3. Module de cellule tel que défini dans la revendication 1 ou la revendication 2, dans lequel la superficie pour le transfert de chaleur, définie par les perles, tiges, barres ou billes (95) faites d'un matériau ayant une grande conductivité thermique, représente au moins 5 fois la superficie de la surface avant de la masse des perles, tiges, barres ou billes faites d'un matériau ayant une grande conductivité thermique, qui sont en contact direct avec le substrat (27).

4. Module de cellule tel que défini dans l'une quelconque des revendications précédentes, dans lequel l'élément réfrigérant (35) au moins occupe essentiellement le volume de la chambre de réfrigérant.

5. Module de cellule tel que défini dans l'une quelconque des revendications précédentes, dans lequel l'admission de réfrigérant (91) se situe sur une paroi latérale (87) du boîtier (79) ou dans la base (85) du boîtier dans la région de cette paroi latérale, tandis que la sortie de réfrigérant (93) se situe dans une paroi latérale opposée (87) ou dans la base (85) dans la région de cette paroi latérale.

6. Module de cellule tel que défini dans la revendication 5, dans lequel l'élément réfrigérant (35) possède une forme telle que la chambre de réfrigérant comprend un collecteur (45) en communication fluidique avec l'admission de réfrigérant (91) et s'étendant le long de la paroi latérale (87) de l'admission, ainsi qu'un collecteur (45) en communication fluidique avec la sortie de réfrigérant (93) et s'étendant le long de la paroi latérale (87) de la sortie.

7. Module de cellule tel que défini dans la revendication 5 ou la revendication 6, dans lequel le boîtier (79) comprend un déversoir (101) s'étendant vers le haut depuis la base (85) à l'intérieur de la paroi latérale (87) de l'admission et définissant une barrière pour le flux de réfrigérant à travers la chambre de réfrigérant depuis l'admission de réfrigérant (91).

8. Module de cellule tel que défini dans l'une quelconque des revendications 5 à 7, dans lequel le boîtier (79) comprend un déversoir (101) s'étendant vers le haut depuis la base (85) à l'intérieur de la paroi latérale (87) de la sortie et définissant une barrière pour le flux de réfrigérant depuis la chambre de réfrigérant vers la sortie de réfrigérant (93).

9. Module de cellule tel que défini dans l'une quelconque des revendications précédentes, dans lequel les perles, tiges, barres ou billes (95) faites d'un matériau ayant une grande conductivité thermique, ont une dimension principale de 0,8 à 2,0 mm.

10. Module de cellule tel que défini dans l'une quelconque des revendications précédentes, dans lequel les perles, tiges, barres ou billes (95) faites d'un matériau ayant une grande conductivité thermique, ont une dimension principale de 0,8 à 1,4 mm.

11. Module de cellule tel que défini dans l'une quelconque des revendications précédentes, dans lequel la densité de compactage des perles, tiges, barres ou billes (95) faites d'un matériau ayant une grande conductivité thermique, diminue à mesure que l'on s'éloigne du substrat (27).

12. Module de cellule tel que défini dans l'une quelconque des revendications précédentes, dans lequel les passages d'écoulement de réfrigérant occupent entre 20 et 30 % du volume de l'élément réfrigérant.

13. Module de cellule tel que défini dans l'une quelconque des revendications précédentes, comprenant un substrat (27) sur lequel la ou les cellules photovoltaïques (5) sont montées et auquel le boîtier (79) est fixé.

14. Module de cellule tel que défini dans la revendication 13, dans lequel le substrat (27) est formé à partir d'une ou plusieurs couches ou comprend une ou plusieurs couches d'un matériau qui consiste en un isolant électrique.

15. Module de cellule tel que défini dans la revendication 13 ou la revendication 14, dans lequel le substrat (27) est formé d'un matériau possédant une conductivité thermique élevée.

16. Module de cellule tel que défini dans la revendication 14, dans lequel le substrat (27) comprend une couche métallisée disposée entre la ou les cellules photovoltaïques et la ou les couches d'isolant électrique.

17. Module de cellule tel que défini dans la revendication 14 ou la revendication 16, dans lequel le substrat (27) comprend une couche métallisée disposée entre la ou les couches d'isolant électrique et l'élément réfrigérant.

18. Procédé de fabrication d'un module de cellule photovoltaïque tel que défini dans l'une quelconque des revendications précédentes, consistant à :
(a) former l'élément réfrigérant (35) en introduisant une masse prédéterminée de plusieurs perles, tiges, barres ou billes (95) faites d'un matériau ayant une grande conductivité thermique, dans un moule ayant une forme prédéterminée, puis chauffer les perles, tiges, barres ou billes faites d'un matériau ayant une grande conductivité thermique, et fritter perles, tiges, barres ou billes les unes aux autres afin de former l'élément réfrigérant ;
(b) placer l'élément réfrigérant (35) dans le boîtier (79) ; et
(c) monter la ou les cellules photovoltaïques (5) sur le boîtier (79).

19. Procédé de fabrication d'un module de cellule photovoltaïque tel que défini dans l'une quelconque des revendications 1 à 17, consistant à :
(a) former l'élément réfrigérant (35) en introduisant une masse prédéterminée de plusieurs perles, tiges, barres ou billes (95) faites d'un matériau ayant une grande conductivité thermique, dans le boîtier (79), puis chauffer les perles, tiges, barres ou billes faites d'un matériau ayant une grande conductivité thermique, et fritter perles, tiges, barres ou billes les unes aux autres afin de former l'élément réfrigérant dans le boîtier ; et
(b) monter la ou les cellules photovoltaïques (5) sur le boîtier (79), par exemple par soudage ou frittage du substrat (27) sur le boîtier (79).

20. Procédé tel que défini dans la revendication 18 ou la revendication 19, consistant à meuler la surface de l'élément réfrigérant (35) définissant une surface de contact avec le substrat de manière à augmenter la superficie de contact entre les perles, tiges, barres ou billes faites d'un matériau ayant une grande conductivité thermique, et le substrat.

21. Procédé de fabrication d'un module de cellule photovoltaïque tel que défini dans l'une quelconque des revendications 1 à 17, consistant à former l'élément réfrigérant (35) en introduisant une masse prédéterminée de plusieurs perles, tiges, barres ou billes (95) faites d'un matériau ayant une grande conductivité thermique, dans le boîtier (79), et à placer le substrat (27) sur le boîtier (79), puis à chauffer les perles, tiges, barres ou billes (95) faites d'un matériau ayant une grande conductivité thermique, et à fritter les perles, tiges, barres ou billes les unes aux autres afin de former l'élément réfrigérant dans le boîtier, et à coller l'élément réfrigérant (35) au boîtier (79) et au substrat (27).

22. Système de génération d'électricité à partir du rayonnement solaire, comprenant :
(a) un récepteur (7) comprenant plusieurs cellules photovoltaïques (5) afin de convertir l'énergie solaire en énergie électrique, et un circuit électrique pour transférer l'énergie électrique émise par les cellules photovoltaïques ; et
(b) un moyen (3) permettant de concentrer le rayonnement solaire sur le récepteur (7) ;
lequel système est **caractérisé en ce que** le récepteur (7) comprend plusieurs modules de cellules photovoltaïques (23) tels que définis dans l'une quelconque des revendications 1 à 16, un circuit électrique qui comprend les cellules photovoltaïques (5) de chaque module (23), et un circuit de réfrigérant qui comprend l'assemblage d'extraction de chaleur (71) de chaque module (23).
